# EUROPEAN PATENT APPLICATION

(11) **EP 4 790 395 A1**
(43) Date of publication of application: **12.08.2026**
(21) Application number: 26157137.6
(22) Date of filing: 09.02.2026
(51) Int. Cl.: G01N 23/04

(54) **RAPID MODE SWITCHING OF CHARGED-PARTICLE-BEAM DEVICES**

(30) Priority: 07.02.2025 US 202519048820
(71) Applicant: FEI Company, Hillsboro OR 97124 (US)
(72) Inventor: HENSTRA, Alexander, Utrecht (NL); BUIJSSE, Bart, Eindhoven (NL); MARSMANS, Daniel Jacobus, Utrecht (NL)
(74) Representative: Boult Wade Tennant LLP

(57) **Abstract**

A method, within a charged particle beam (CPB) microscope, of rapidly switching between a first imaging or data acquisition mode and a second imaging or data acquisition mode, comprises: activating a switchable electrostatic multipole of the CPB microscope to either cause or enable the CPB microscope to generate a first set of one or more images or data sets, the first set of one or more images or data sets comprising information relating to a sample in accordance with the first imaging or data acquisition mode; and de-activating the switchable electrostatic multipole to either cause or enable the CPB microscope to generate a second set of one or more images or data sets, the second set of one or more images or data sets comprising information relating to the sample in accordance with the second imaging or data acquisition mode.

## Description

### TECHNICAL FIELD

The present application relates, in general, to charged particle beam microscopes and charged particle beam microscopy and, more particularly, to Transmission Electron Microscopy (TEM) and microscopes therefor as well as to Scanning Transmission Electron Microscopy (STEM) and microscopes therefor.

### BACKGROUND

Many biological, chemical and chemical analysis techniques require the acquisition of spatially-resolved data relating to the areal or volumetric distribution of various structures, molecules and/or elements within one or more samples. Electron microscopy, including Scanning Electron Microscopy (SEM), Transmission Electron Microscopy (TEM) and Scanning Transmission Electron Microscopy (STEM), is recognized as a highly versatile set of techniques for obtaining a variety of useful measurements pertaining to extremely small samples. A single electron microscope apparatus may, in many cases, be configured to obtain complementary measurements of different properties of a sample by switching between different modes of operation, where each mode probes a different property of the sample. For example, either a TEM apparatus or an SEM may routinely operate in both an imaging mode, in which the configurations of sample features (e.g., shapes, grain boundaries, etc.) may be recorded, and in a diffraction mode, from which crystallinity, crystal structures and molecular structures may be determined. Some specially configured SEM and TEM apparatuses may additionally be capable of operating in one or more spectroscopic modes (e.g., Energy Dispersive Spectroscopy, commonly abbreviated as EDS, Electron Energy Loss Spectroscopy, abbreviated as EELS, Cathodoluminescence spectroscopy, CL, etc.) in which elemental composition or other physical properties of a sample may be determined. A less common operational mode that is applicable to TEM apparatuses is an alignment mode in which a laser beam is aligned relative to an electron beam for use with an image-contrast-enhancing laser phase plate.

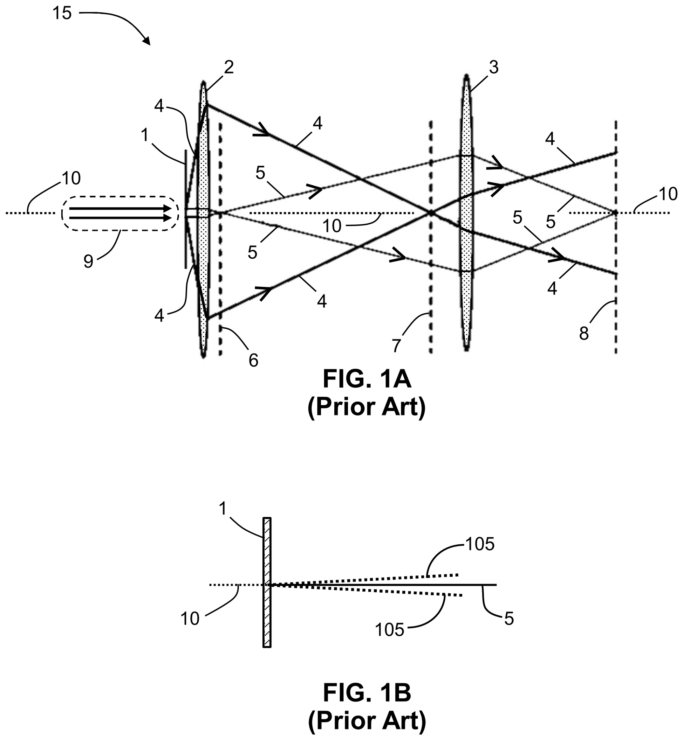

FIG. 1A is a schematic depiction of conventional axial ray paths and field ray paths through a substage assembly **15** (i.e., an image projection system) of a transmission electron-beam microscope that is capable of being configured either in a sample-image-generating mode or in a diffraction-pattern-generating mode. The particular ray paths that are shown in FIG. 1A are pertinent to diffraction pattern generation. Axial rays **4** are generated from electrons that that are scattered or otherwise emitted from a sample (not shown in FIG. 1A but disposed on sample plane **1)** at an angle to the axis of incidence **10** of an electron beam **9.** Such axial rays **4** are caused to come to a focus, as a real image, at an intermediate image plane **7** by objective lens system **2.** A projection lens system **3,** which may comprise more than one lens, is positioned at a side of the intermediate image plane **7** that is opposite to the side from which the electrons are focused onto the image plane. Although each of the objective lens system **2** and the projection lens system **3** may comprise several separate lenses, for simplicity only a single representative lens is shown in each instance, as well as in other instances in which lenses are mentioned herein. As depicted in FIG. 1A, the projection lens system **3** is positioned and is operated such that the focal length of the projection lens system is greater than the separation distance between the intermediate image plane **7** and the projection lens system **3.**

Under the operation shown in FIG. 1A, the axial rays **4** are not focused at the detector plane **8** and, thus, an image of the sample is not formed. Instead, field rays **5** of the electron beam **9** are caused to come to a focus at the detector plane. The field rays **5** pass into and through the objective lens **2** along trajectories that are essentially parallel to an electron microscope column axis **10.** The objective lens system **2** causes the field rays **5** to focus at the back focal plane **6** of the objective lens. In the absence of any trajectory-changing interaction of the field ray electrons with the sample, a single small spot, which is an image of an electron source (not shown in the drawings), would be produced at the objective lens back focal plane **6** by the focusing action. However, the actual image that appears at the back focal plane **6** is highly sensitive to angular deviations of some rays that may occur as a result of interactions between the electrons with the sample. Such interactions, which include electron scattering and, more prominently, electron diffraction in case of crystalline samples, are shown as scattered beams cones **105** in FIG. 1B, which is an enlargement of a portion of FIG. 1A. Thus, the real image at the back focal plane **6** in case of a crystal comprises a plurality of focused spots, each of which may be produced by a separate diffracted beam.

The aforementioned positioning and operation of the projection lens system **3** is such that a focused image of the back focal plane **6** is transferred to or imaged onto the detector plane **8** at which it may be acquired as a diffraction pattern. During acquisition of the diffraction pattern, an adjustable aperture may be positioned at the intermediate image plane **7** (also known as a "selected aperture" plane) so as to control the region of the sample from which the diffracted electron beams are collected. Accordingly, the intermediate image plane is also commonly referred to as a "selected aperture" plane. It should be kept in mind that the depiction in FIG. 1A is highly schematic. In actual practice, the substage assembly **15** may include one or more additional lenses that either magnify or correct the image that is projected onto the detector plane **8.** To obtain an image of the sample, as opposed to a diffraction pattern, the strength of the transfer lens system **3** as well as of any additional substage lenses may be conventionally adjusted, by adjusting the lens currents of the magnetic lenses so that the real image of the sample at intermediate image plane **7,** as formed by the axial rays **4, 104** is projected onto the detector plane, preferably in magnified form. Such adjustments simultaneously cause the field rays **5** to be out of focus at the detector plane.

The conventional method for switching between imaging and diffraction modes has been advantageously used in TEM studies for many years for the purpose of studying inter-atomic structures of various molecules and crystalline materials. However, in recent years, it has been recognized that the conventional mode-switching methods are not adequate for studies in which the two modes may be required to be simultaneously available or in which extremely rapid switching between the two modes is required. For example, U.S. Pre-Grant Publication 2021/0302333-A1 describes methods for determining phase information, in addition to intensity information, from electrons that are observed in a diffraction plane, by letting the electron beam interfere with a simultaneously-generated second reference electron beam. To implement such methods, the inventors of the aforementioned publication utilized a TEM system that includes a "bifocal beamformer" device as described in US Pre-Grant Publication 2021/0305007-A1. With reference to the same bifocal beamformer device, US Pre-Grant Publication 2021/0305010-A1 teaches methods, during which two electron beams are simultaneously directed onto a sample, in which both diffraction and imaging are conducted to identify movement of a sample during progressive tilting of the sample while collecting data for three-dimensional molecular or crystallographic reconstructions.

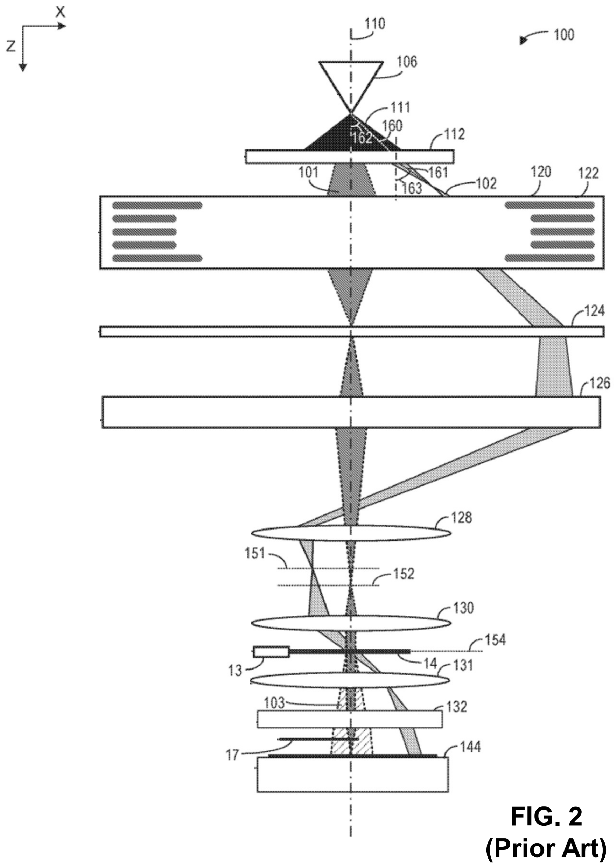

FIG. 2 depicts a bifocal multibeam charged particle transmission microscope system **100** as described in US Pre-Grant Publication 2021/0305010-A1. The depiction of FIG. 2 is a schematic cross section of the microscope system taken parallel to the x-z plane (where, by convention, the z-axis is assumed parallel to a primary axis **110,** generally vertically oriented, of a not illustrated optical column of the system **100).** Components housed within the optical column are provided for forming two charged particle beams with different focal properties. The optical column includes therein a charged particle source **106** and other optical components such as bifocal beamformer **112,** focusing component **120,** focusing column **126,** a multipole element **124,** and mini-condenser optics system **128.** In some examples, one or more lenses are positioned between the charged particle source **106** and the bifocal beamformer, which enables tuning of the current in both beams. These lenses are preferably electrostatic lenses.

According to the teachings of US publication 2021/0305010-A1, the charged particle beam **111** generated by the charged particle source **106** is split into the first charged particle beam **101** and the second charged particle beam **102** by the bifocal beamformer positioned downstream of the charged particle source **106.** The first charged particle beam **101** is an axial beam that travels along the primary axis **110** of the optical column. The primary axis **110** may be the emission axis of the charged particle source **106.** The second charged particle beam **102** is an off-axial beam that travels along an axis **161** different from the primary axis **110.** The bifocal beamformer **112** modifies the focal property of at least one of the first and second charged particle beams, so that the first and second charged particle beams have different focal properties. The angle **163** between primary axis **110** and beam axis **161** of the second charged particle beam exiting the bifocal beamformer **112** is greater than the angle **162** between the primary axis **110** and the beam axis **160** of the portion of charged particle beam **111** that forms the second charged particle beam.

According to the teachings of US publication 2021/0305010-A1, the bifocal beamformer may be a microelectromechanical system (MEMS) or an aperture lens array. In order to change the focal properties of at least one of the charged particle beams, the bifocal beamformer may apply at least a quadrupole lensing effect to the at least one of the charged particle beams that focuses, stigmates, and/or otherwise modifies at least one of the beams such that the corresponding focal properties of the beams are made different. The quadrupole lensing effect may focus the second charged particle beam in the x-z plane and expand the second charged particle beam in the y-z plane. The bifocal beamformer may further be configured to generate at least a dipole electromagnetic field that causes at least one of the beams to be deflected.

After exiting the bifocal beamformer **112,** both the first and second charged particle beams sequentially pass through focusing component **120,** multipole element **124,** focusing column **126,** condenser optics system **128,** and pre-sample objective lens **130,** before irradiating sample **14.** The sample **14** locates at the sample plane **154** when the sample is not tilted. Sample plane **154** is a plane orthogonal to the primary axis **110.** The focusing component **120** positioned downstream of the bifocal beamformer accelerates/decelerates, focuses, and/or directs the first charged particle beam **101** and the second charged particle beam **102** towards the focusing column **126** positioned downstream of the focusing component **120.** The focusing component **120** may include an accelerator **122** that focuses and accelerates the charged particle beams.

The multipole element **124** is positioned at a focal plane of the first charged particle beam between the focusing component **120** and the focusing column **126** to adjust the beam shape of the second charged particle beam. The multipole element **124** does not affect the first charged particle beam. The multipole element **124** may be a stigmator for applying a quadrupole lensing effect complementary to the quadrupole lensing effect of the bifocal beamformer, in order to make the second charged particle beam profile to be cylindrically symmetric. The combined action of the bifocal beamformer **112** and the multipole element **124** causes the first and the second charged particle beams to have different focal planes near the sample plane **154.**

As taught in US publication 2021/0305010-A1, the focusing column **126** and the condenser optics system **128** bring the deflected second charged particle beam close to the primary axis **110.** The first charged particle beam and the second charged particle beam focus at different planes **(152** and **151)** upstream from the pre-sample objective lens **130.** The first charged particle beam and the second charged particle beam both irradiate a region of interest of the sample after passing through pre-sample objective lens **130** positioned downstream of the condenser optics system **128.** The beam axes of the first and second charged particle beams may intercept at the sample plane **154.** Either one of the first and second charged particle beams may be convergent (e.g., focused) or non-convergent at the sample plane. The second charged particle beam impinges onto the sample **14** that is mounted on sample holder **13** with a non-zero tilt angle relative to the first charged particle beam.

Detector **144** is positioned downstream from the projection optics **132,** wherein the diffraction pattern is focused onto the detector through the post-sample objective lens **131** and the projection optics **132.** The pre-sample objective lens **130** and the post-sample objective lens **131** may be combined into a magnetic immersion lens. The unscattered beam may be blocked by beam stopper **17** positioned between the projection optics **132** and detector **144.** Scattered charged particles **103** pass through projection lenses **132** and form the diffraction pattern at a first region of the detector **144.** The collected scattered charged particles (such as scattered electrons) form a diffraction pattern, such as a selected area electron diffraction (SAED) pattern. The second charged particle beam forms the sample image at a second region of the detector **144.** The first region and the second region are offset from each other. That is, the central locations of the first region and the second region are different. The overall magnification of bifocal image, which may include both the sample image and the diffraction pattern, can be adjusted by the projection system. The sample image may show the 2D contour or outline of the crystal.

Employment of the above-described bifocal beamformer apparatus within a transmission electron microscope apparatus requires complex modification of an existing microscope with associated additional cost. Further, known charged-particle-beam mode switching techniques are burdened by hysteresis effects that delay the start of acquisition of reliable data after the switching event. Faster mode switching is required for investigation of some samples that either move (either intentionally or unintentionally), degrade, decompose, react or otherwise undergo changes during the course of microscopic investigation. Accordingly, there is a need in the art of charged particle beam microscopy for more rapid methods of switching between imaging and diffraction modes using simple components that do not require significant modification of existing systems.

### SUMMARY

The present inventors have recognized that rapid mode-of-operation switching may be achieved by activating and deactivating a small number of additional electrostatic multipole components (e.g., a single electrostatic multipole component) and, optionally, one or more stigmator components (i.e., magnetic multipoles) that are incorporated into an otherwise conventional charged particle beam path of an electron microscope. Electrostatic multipole components, in particular, may be rapidly switched between activated and inactivated states. For instance, using such switchable electrostatic multipole components, it is possible, at the time of this writing, to achieve switching times of less than 50 nanoseconds, thereby enabling cycle times of less than 100 nanoseconds. Using such rapidly switchable optics, it is possible to generate pseudo-simultaneous overlaid charged-particle-beam images, where each image is obtained using a different mode of operation. As used herein, the term "pseudo-simultaneous" means that two or more modes can be generated with a certain duty cycle (e.g., a 1:10 duty cycle using two overlaid modes, to be determined by user) within a typical camera frame time (e.g., 1 ms to 10 ms). For example, using Scanning Transmission Electron Microscopy (STEM), it is attractive to generate the diffraction pattern during the beam fly-back time.

According to a first aspect of the present disclosure, there is described a method, within a charged particle beam (CPB) microscope, of rapidly switching between a first imaging or data acquisition mode and a second imaging or data acquisition mode, comprising:
activating a switchable multipole element of the CPB microscope, wherein the switchable multipole element is configured to create, when activated, a quadrupole field, so as to either cause or enable the CPB microscope to generate a first set of one or more images or data sets, the first set of one or more images or data sets comprising information relating to a sample in accordance with the first imaging or data acquisition mode; and
de-activating the switchable multipole element so as to either cause or enable the CPB microscope to generate a second set of one or more images or data sets, the second set of one or more images or data sets comprising information relating to the sample in accordance with the second imaging or data acquisition mode.

The switchable multipole element may be a switchable electrostatic multipole element. A switching time of the switchable electrostatic multipole element may be not greater than 100 milliseconds or, alternatively, not greater than 10 milliseconds or, alternatively, not greater than 1 millisecond or, alternatively, not greater than 500 microseconds or, alternatively, not greater than 10 microseconds or, alternatively, not greater than 1 microsecond or, alternatively, not greater than 500 nanoseconds or, alternatively, not greater than 50 nanoseconds. The switchable multipole element that is configured to create a quadrupole field may be disposed at or proximal to a selected aperture plane of a substage assembly of a charged-particle-beam microscope system. Optionally, an additional multipole element (either a stigmator or an electrostatic multipole element) may be disposed at or proximal to a back focal plane of a condenser lens of the substage assembly. The additional multipole element may remain activated may remain activated while the switchable multipole element at or proximal to the selected aperture plane is switched from activated to de-activated and vice versa.

According to some embodiments, the switching time of the of the switchable multipole element is not greater than 100 milliseconds, or, alternatively, is not greater than 10 milliseconds, or, alternatively, is not greater than 1 millisecond or, alternatively, is not greater than 500 microseconds or, alternatively, is not greater than 10 microseconds or, alternatively, is not greater than 1 microsecond or, alternatively, is not greater than 500 nanoseconds or, alternatively, is not greater than 50 nanoseconds.

According to some embodiments, the switchable electrostatic multipole element is repeatedly activated and de-activated, within a single detector frame time, in accordance with a duty cycle, wherein each activating causes the CPB microscope to generate a component image in accordance with the first imaging mode and each deactivating causes the CPB microscope to generate a component image in accordance with a second imaging mode, and wherein a superposition of the component images generates a multiple-exposure composite image. In such instances, the switchable electrostatic multipole element may be disposed within an image projection system of the CPB microscope and, if so, the image projection system may further comprise an active stigmator disposed at or proximal to a back focal plane of an objective lens,
wherein each activating and deactivating of the switchable electrostatic multipole element comprises activating and deactivating, respectively, an electrostatic multipole element that is positioned at a selected aperture plane of an objective lens system of the image projection system, and
wherein each activating corresponds to generation of an image of the sample and each deactivating corresponds to generation of an electron diffraction pattern from the sample.
Alternative embodiments may include, instead of the single stigmator, a pair of active stigmators that are disposed between the back focal plane and a projection lens. The single stigmator or, alternatively, pair of stigmators may remain activated while the switchable electrostatic multipole is repeatedly activated and de-activated.

According to various other embodiments in which the switchable electrostatic multipole element is disposed within an image projection system of the CPB microscope, the image projection system may comprise a laser phase plate that is disposed at or proximal to a diffraction plane that is conjugated to the back focal plane and onto which a laser beam is directed,
wherein each activating and deactivating comprises, respectively, activating and deactivating a switchable electrostatic multipole element that is disposed at or proximal to an image plane conjugated to the sample plane, and
wherein each activating causes superposed images of the sample and of laser interferences fringes to be acquired by a detector.

According to various other embodiments of the first aspect of the present disclosure, the switchable electrostatic multipole element may be disposed within a CPB microscope column that directs a beam of charged particles onto a sample. In such embodiments, the switchable electrostatic multipole element may be disposed between a focal point of a beam condenser lens system of the CPB microscope column and an aberration correction system of the CPB microscope column,
wherein activating of the switchable electrostatic multipole element causes the CPB microscope column to deliver a focused probe beam onto the sample that enables a scanning transmission microscope (STEM) operational mode, and
wherein de-activating of the switchable electrostatic multipole element causes the CPB microscope column to deliver a parallel (or nearly parallel) beam onto the sample that enables a transmission electron microscope (TEM) operational mode.
In some instances, the focused probe beam may focus to a sub-Ångstrom-diameter spherical probe beam that is delivered to a selected point on the sample. The aberration correction system may comprise a spherical aberration corrector of the hexapole type that comprises two active magnetic hexapole elements that generate a negative spherical aberration correction.

According to a second aspect of the present disclosure, a charged particle beam (CPB) microscope is provided, the CPB microscope comprising:
a charged particle beam source;
a CPB column configured to transmit a charged particle beam from the charged particle beam source to a sample;
an optics assembly comprising transfer optics that are configured to transfer charged particles that are either transmitted through the sample or scattered by the sample to a detector; and
a switchable electrostatic multipole member of either the CPB column or the optics assembly, wherein the switchable electrostatic multipole member is configured to, when activated, generate a quadrupole field such that:
   activating the switchable electrostatic multipole member either causes or enables the CPB microscope to generate a first set of one or more images or data sets, the first set of one or more images or data sets comprising information relating to the sample in accordance with a first imaging or data acquisition mode; and
   de-activating the switchable electrostatic multipole member either causes or enables the CPB microscope to generate a second set of one or more images or data sets, the second set of one or more images or data sets comprising information relating to the sample in accordance with a second imaging mode.

A first such CPB microscope is provided as a Transmission Electron Microscope (TEM) comprising:
an image projection system comprising:
an objective lens system configured to receive electron rays from a sample and having a back focal plane;
a projection lens system disposed between the objective lens system and a detector; and
a switchable electrostatic multipole element that is configured to generate a quadrupole field positioned at an or proximal to an intermediate image plane (e.g., a selected aperture plane) of the objective lens system,
wherein activation of the switchable electrostatic multipole element causes an image of the sample to be projected onto the detector and deactivation of the electrostatic multipole element causes a diffraction pattern from the sample to be projected onto the detector.
The image projection system of the TEM may further comprise:
a stigmator or second electrostatic multipole element that is configured to generate a quadrupole field when activated positioned at or proximal to a back focal plane of the objective lens system,
wherein the stigmator or second electrostatic multipole element remains activated during the activation and de-activation of the switchable electrostatic multipole element.

According to a third aspect of the present disclosure, a charged-particle beam column of a transmission electron microscope (TEM) or scanning transmission microscope (STEM) system is provided comprising:
a switchable electrostatic multipole element that is configured to generate a quadrupole field and that is further configured to be alternately activated and deactivated and that is disposed proximal to a first lens system of a probe beam delivery system, wherein the first lens system is configured to receive a diverging beam from a condenser lens system of the electron microscope,
wherein activation of the switchable multipole element causes a focused charged particle probe beam to be delivered onto the sample from the charged particle beam delivery system and deactivation of the quadrupole causes a collimated charged particle beam to be delivered onto the sample from the charged particle beam delivery system.
The charged particle beam column may further comprise:
a spherical aberration corrector of the hexapole type that that is disposed between the switchable quadrupole and the sample and that comprises two magnetic hexapole elements that generate a negative spherical aberration correction.

According to a fourth aspect of the present disclosure, there is provided an improved substage assembly for a Transmission Electron Microscope (TEM) that comprises: an objective lens system; a first transfer lens system positioned downstream from the back focal plane of the objective lens system; a second transfer lens system that is disposed at or proximal to an intermediate image plane that is established by the objective lens system and the first transfer lens system; a laser phase plate disposed proximal to the intermediate diffraction plane; and a laser that directs a laser beam onto the laser phase plate; the improvement comprising:
a switchable multipole element that is configured to, when activated, generate a quadrupole field and that is disposed proximal to the intermediate image plane and that is configured to be repeatedly activated and deactivated.

According to any of the above-described aspects of the present disclosure, a switchable multipole element or member that is configured to create, when activated, a quadrupole field may comprise a simple quadrupole element or member. Likewise, according to any of the above-described aspects, a switchable electrostatic multipole element or member that is configured to create, when activated, a quadrupole field may comprise a simple electrostatic quadrupole element or member.

According to any of the above-described aspects of the present disclosure, a switchable electrostatic multipole element or member that is configured to generate a quadrupole field may have a switching time, either from a de-activated state to an activated state or from an activated state to a de-activated state, that is not greater than 100 milliseconds or, alternatively, is not greater than 10 milliseconds or, alternatively, is not greater than 1 millisecond or, alternatively, is not greater than 500 microseconds or, alternatively, is not greater than 10 microseconds or, alternatively, is not greater than 1 microsecond or, alternatively, is not greater than 500 nanoseconds or, alternatively, is not greater than 50 nanoseconds.

### BRIEF DESCRIPTION OF THE DRAWINGS

The above noted and various other aspects of the present invention will become apparent from the following description which is given by way of example only and with reference to the accompanying drawings, not necessarily drawn to scale, in which:
FIG. 1A is a schematic depiction of axial ray paths and field ray paths through a substage assembly of a transmission electron microscope (e.g., a transmission electron microscope, TEM) that is configured, in conventional fashion, to display a diffraction pattern of a sample;
FIG. 1B is an enlargement of a portion of FIG. 1A;
FIG. 2 is an illustration of a known bifocal multibeam charged particle system that is configured to simultaneously provide first and second charged particle beams that may provide an image of a sample from the first charged particle beam and diffraction information relating to the sample from the second charged particle beam;
FIG. 3A is a schematic depiction of axial ray paths through a version of the substage assembly of FIG. 1A that is modified, in accordance with the present teachings, by the inclusion therein of two switchable electrostatic quadrupole optical components which, when activated, cause an electron diffraction pattern to be acquired by a detector and that, when deactivated, permit an image of the sample to be projected onto the detector;
FIG. 3B is a schematic depiction of field ray paths through the modified substage assembly of FIG. 3A when both electrostatic quadrupole optical components are activated;
FIG. 4 is a schematic depiction of field ray paths through a second modified version of the substage assembly of FIG. 1A that is modified, in accordance with the present teachings by the inclusion therein of a stigmator at the back focal plane of the objective lens and one electrostatic quadrupole optical component wherein, when the electrostatic quadrupole is not activated, an electron diffraction pattern is caused to be acquired by the detector;
FIG. 5A is an image of a sample generated by an electron microscope substage assembly in which optical components are arranged as in FIG. 4 but with two stigmators and with the quadrupole element de-activated;
FIG. 5B is a diffraction pattern obtained using the same system and same sample as imaged in FIG. 5A but with the electrostatic quadrupole component activated;
FIG. 6A is a portion of a set of optical components within a portion of an electron beam illumination column that are configured and operated, in a known fashion, to deliver a collimated electron beam onto a sample for enabling a Transmission Electron Microscopy (TEM) mode of operation;
FIG. 6B is a modified version of the optical components of FIG. 6A that is modified, in accordance with the present teachings, by the inclusion of an additional switchable electrostatic quadrupole component so that the illustrated rays are converted into convergent rays at the sample, thereby focusing the beam to a small spot size (as small as sub-Ångstrom), thereby allowing a highly-magnified image of the sample to be detected in a Scanning Transmission Electron Microscopy (STEM) mode of operation;
FIG. 7A is a schematic depiction of a portion of a set of substage components of a transmission electron beam microscope that are provided in a known configuration that includes a laser phase plate for image contrast enhancement;
FIG 7B is a modified version of the substage components of FIG. 7A that is modified, in accordance with the present teachings, by the inclusion of a switchable electrostatic quadrupole element at or near the first image plane after the objective lens, whereby activation of the quadrupole causes two field-ray foci to occur on opposite sides of the laser phase plate, thereby permitting imaging of laser fringes for the purpose of sample alignment;
FIG. 8 is a collection of fringe patterns obtained using a TEM substage configuration that includes both a laser phase plate disposed at a diffraction plane as well as a quadrupole mode switching apparatus disposed upstream from the laser phase plate. Horizontal and vertical panels show the effect of exciting the quadrupole field in two distinct orientations;
FIG. 9A is a composite image, acquired during readout of a STEM detector, where the electrostatic quadrupole is activated to focus field rays 50% of the time (as in FIG. 7B) and where, for the remaining 50% of the time, the quadrupole is de-activated (as in FIG. 7A). Results are obtained by applying a 50-Hertz cycled on/off square wave voltage profile to the quadrupole therein;
FIG. 9B is a composite TEM image comprising a diffraction image and a Ronchigram of the STEM probe employed during the image acquisitions of FIG. 9A;
FIG. 9C is a schematic depiction of the voltage waveform applied during acquisition of the composite image of FIG. 9A; and
FIG. 10 is a set of block diagrams of a controller and power supply for a microscope system according to certain aspects of the present disclosure.
FIG. 11 illustrates a known Micro-Electrical Mechanical System (MEMS) bifocal beam-forming device as may be modified for use within the present invention as a MEMS electrostatic quadrupole.
FIG. 12 illustrates a top-down schematic view of another MEMS bifocal beam-forming device.
FIG. 13A illustrates a top-down schematic view of another known MEMS bifocal beam-forming device that comprises seven electrodes and that may be modified for use within the present invention as a MEMS electrostatic quadrupole.
FIG. 13B depicts a modified form of the MEMS device of FIG. 13A that may be employed within the present invention as an electrostatic quadrupole.

### DETAILED DESCRIPTION

The following description is presented to enable any person skilled in the art to make and use the invention and is provided in the context of a particular patent application and its requirements. Various modifications to the described embodiments will be readily apparent to those skilled in the art and the generic principles herein may be applied to other embodiments. Thus, the present invention is not intended to be limited to the embodiments and examples shown but is to be accorded the widest possible scope in accordance with the features and principles shown and described. To fully appreciate the features of the present invention in greater detail, please refer to FIGS. 1-13 in conjunction with the following description.

In the description of the invention herein, it is understood that a word appearing in the singular encompasses its plural counterpart, and that a word appearing in the plural encompasses its singular counterpart, unless implicitly or explicitly understood or stated otherwise. Furthermore, it is understood that, for any given component or embodiment described herein, any of the possible candidates or alternatives listed for that component may generally be used individually or in combination with one another, unless implicitly or explicitly understood or stated otherwise. Moreover, it is to be appreciated that the figures, as shown herein, are not necessarily drawn to scale, wherein some of the elements may be drawn merely for clarity of the invention. Also, reference numerals may be repeated among the various figures to show corresponding or analogous elements. Any list of candidates or alternatives is merely illustrative, not limiting, unless implicitly or explicitly understood or stated otherwise.

Unless otherwise defined, all technical and scientific terms used herein have the meaning commonly understood by one of ordinary skill in the art to which this invention belongs. In case of conflict, the present specification, including definitions, will control. It will be appreciated that there is an implied "about" prior to any quantitative terms mentioned in the present description, such that slight and insubstantial deviations are within the scope of the present teachings. Whenever "substantially," "approximately," "about," or similar language is explicitly used in combination with a specific value, variations up to and including 10% of that value are intended, unless explicitly stated otherwise. In addition, the use of "comprise", "comprises", "comprising", "contain", "contains", "containing", "include", "includes", and "including" are not intended to be limiting. As used herein, "a" or "an" also may refer to "at least one" or "one or more." Also, the use of "or" is inclusive, such that the phrase "A or B" is true when "A" is true, "B" is true, or both "A" and "B" are true.

As used herein, the term "stigmator" is used to refer exclusively to magnetic multipole optics components and the terms "quadrupole" and "multipole" are used to exclusively refer to electrostatic multipole optics components, with the exception that these terms are not intended to refer to dipole optics components. As used herein, the terms "activation" and "activated", when used in reference to a component of a charged-particle-beam microscope at a particular position within the charged-particle-beam microscope, refer to application of a first set of one or more voltages to electrodes of the component that modify the trajectories of charged particles that pass through or past the component, relative to the trajectories that would exist if the said component were not present at that position, such that a first desired mode of operation is achieved. As used herein, the meaning of the terms "deactivation" and "deactivated", when used in reference to such a component at its position, refer to application of a second set of one or more voltages (or no voltages) to electrodes of the component that cause the trajectories of charged particles that pass through or past the component to be essentially identical to what those trajectories would otherwise be if the component were not actually present at that position, whereby a second desired mode of operation is achieved. In the above, the phrase "cause the trajectories of charged particles ... to be essentially identical to what those trajectories would otherwise be if the component were not present at that position" means that the particle trajectories are sufficiently similar to the trajectories that would be realized in the absence of the component to the extent that any data collected under the second desired mode of operation is similar, at or above a threshold value of a similarity metric and/or at or above a threshold value of a data quality metric, to the data that would be otherwise collected in the absence of the component. Any suitable similarity metric or quality metric may be employed.

The usage, herein, of optics-related terms such as "optic", "optics", "optical", "beam", "beams", "beam path", "ray", "rays", "lens", "lenses", "focus", "focal point", "collimate" and the like are not intended to imply that such optics, optical components, beams, rays, lenses, foci, collimation, etc. either pertain to or are for the purpose of manipulating photons (i.e., visible and non-visible light). Neither does the use of such terms imply the use of photon transparent materials, such as silica, fluorite, etc., for the purpose of manipulating the various beams, rays, etc. Instead, as used herein, these terms pertain to beams and rays of charged particles - generally electrons - as well as to the control of the trajectories of such charged particles by electromagnetic lenses, objectives, stigmators and other components that comprise electrodes. As used herein, the term "quadrupole" includes multipole apparatuses (e.g., hexapoles, octupoles, etc.) that are configured to mainly generate a quadrupole field. As used herein, a quadrupole device may comprise either an electrostatic quadrupole or a magnetic quadrupole. Also, as used herein, the term "substage optical system" refers to optics lenses and/or other optics components that are employed to divert or otherwise manipulate charged particle beams and their ray paths after such beams have been transmitted through a sample, regardless of the relative positions (i.e., above, below, astride, etc.) between the sample and such optics lenses and/or other optics components.

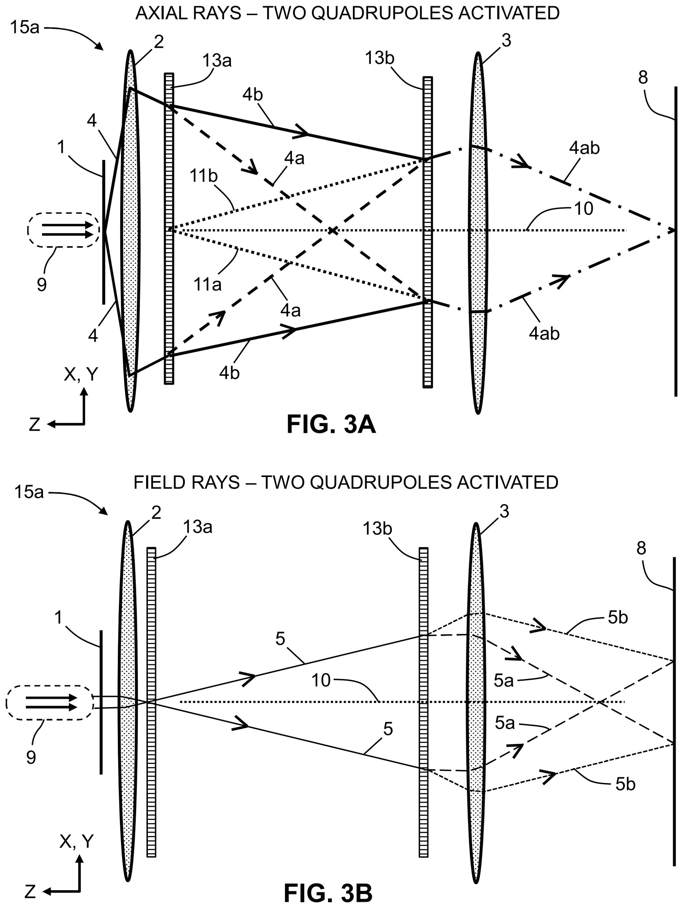

FIGS. 3A-3B are schematic depictions of axial-ray and field-ray paths, respectively, through a modified version **15a** of the substage assembly of FIG. 1A that is modified in accordance with the present teachings. Specifically, the substage assembly **15a** is modified, relative to the conventional assembly (e.g. FIG. 1A) by inclusion of a first electrostatic quadrupole optical component **13a** that is disposed at the back focal plane **6** of the objective lens system **2,** and a second electrostatic quadrupole optical component **13b** that is disposed at the intermediate image plane **7** (i.e., a selected aperture plane of the objective lens system **2.** The first electrostatic quadrupole **13a** is optional and, if present, may remain activated during mode-switching operations. Alternatively, the first quadrupole **13a,** may be a magnetic quadrupole (i.e., a stigmator) that remains activated throughout operation. The second quadrupole, **13b** is an electrostatic quadrupole which, for purposes of mode switching, may be operated in either a "de-activated" state or otherwise in an "activated" state.

FIGS. 3A and 3B illustrate ray paths of axial-ray electrons and field-ray electrons, respectively, when the electrostatic quadrupoles **13a, 13b** are simultaneously in an activated state. It should be noted that only a few selected rays are illustrated in this and other accompanying figures. Each point on the sample that is illuminated by the electron beam **9** will produce a multitude of rays emanating from the sample in a cone-like configuration. The rays that are depicted in FIGS. 3A and 3B, as well as in other accompanying figures, represent only a few selected rays that all emanate from a same common point on the sample (on sample plane **1).** As depicted in FIG. 3A, the first electrostatic quadrupole **13a** is configured so as to separate and divert each axial ray into a first sub-ray **4a** that is within the X-Z plane and a second sub-ray **4b** that is within the Y-Z plane.

The second quadrupole, when activated causes the trajectory of each ray **4a,** which is in the x, z plane, to propagate, between the second quadrupole and the detector **8,** at the same distance from the axis **10** as the corresponding ray **4b,** which is in the y, z plane. This diagram thus shows that the axial rays are circular as they pass through the second electrostatic quadrupole **13b** and the projection lens **3.** (Note that the vertical axis in FIGS. 3A-3B pertains to both x and y dimensions.) After passing through the second electrostatic quadrupole, the projections of the axial rays overlap and are therefore denoted as rays **4ab**. The axial rays **4ab** are then focused onto the detector plane **8** as an image of the sample. Thus, with both electrostatic quadrupoles **13a, 13b** configured in their activated states, as shown, the sample plane and detector plane are conjugate to one another and, thus, an image of the sample is projected onto and recorded by the detector. The inventors have discovered that an astigmatic image of the sample may be projected onto the detector as a usable overview image if the first electrostatic quadrupole **13a** is removed, deactivated, or otherwise absent. In such circumstances, the beam deflection strength of the sole quadrupole **13b,** which is controlled by the voltages that are applied to the quadrupole electrodes, will be different than the strength that is used in operation of the configuration shown in FIG. 3A.

It should be noted that, according to the configuration illustrated in FIG. 3A, if the quadrupoles are subsequently deactivated, then the detector plane is, instead, conjugate to the back focal plane **6** of the objective lens system **2,** as is indicated by the dotted back-extrapolated projection lines **11a, 11b.** Thus, simple activation and de-activation of the electrostatic quadrupoles **13a, 13b,** without other optics adjustments, can cause the detector to record either a sample image or a diffraction pattern, respectively. Advantageously, the image of the sample may be moved to a corner of the field of view of a detector by a slight shift of the incident electron beam **9,** without significant disruption of the diffraction pattern. This permits a user to, if desired, record a double-exposure composite image by obtaining multiple exposures with the quadrupoles both activated and de-activated.

FIG. 3B illustrates ray paths of field-ray electrons when the quadrupoles **13a, 13b** are simultaneously in an activated state or, equivalently, when only quadrupole **13b** is activated. Because the first quadrupole **13a** is located at a plane at which the field rays are brought to a focus, the activation of this quadrupole does not affect the trajectories of the field rays **5** as they pass through this plane. The paths of the field rays **5** thus remain identical to the corresponding paths depicted in FIG. 1A between the two quadrupoles. As the field rays **5** encounter the second quadrupole **13b,** they are separated into sub-rays **5a, 5b** as shown. Since the various sub-rays **5a**, **5b** fail to converge to a single focal point at detector plane **8,** no diffraction pattern image is recorded by the detector. Thus, in summary, FIG. 3A shows that a focused image of the sample is present at the detector plane, and FIG. 3B provides an indication of the magnification associated with that image. As noted above, upon deactivation of both quadrupoles, the ray paths revert to those shown in FIG. 1A, at which time a diffraction pattern image may be recorded.

Still with reference to FIGS. 3A-3B, it should be noted that, if only quadrupole **13a** is activated, while quadrupole **13b** remains inactivated, then, since the quadrupole **13a** is positioned at the location of the back focal plane (i.e., the "diffraction plane") **6** of lens system **2,** then the detector plane **8** becomes conjugate to the diffraction plane **6** (cf., the ray paths labeled **11a, 11b** and **4ab** in FIG. 3A). In this situation, the detector will record a focused diffraction pattern.

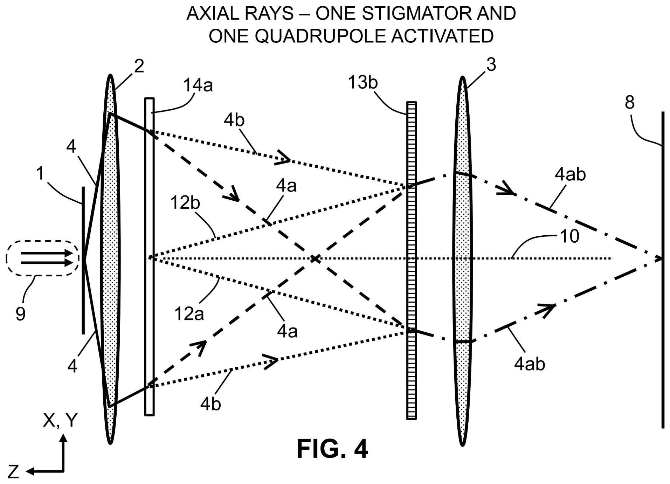

FIG. 4 is a schematic depiction of field ray paths through a second modified version of the substage assembly of FIG. 1A that is modified relative to the modified version shown in FIGS. 3A-3B, by the replacement of the first electrostatic quadrupole (i.e, quadrupole **13a)** by a stigmator **14a** (e.g., an electromagnetic quadrupole) whereby the stigmator **14a** is positioned at the back focal plane of the objective lens system **2** and remains activated at all times. As shown in FIG. 4, the operation of the electrostatic quadrupole **13b** may be controlled such that the axial rays **4** are ultimately focused on the detector plane **8,** thereby projecting an image of the sample onto the detector plane. Since, other than the replacement of the first quadrupole by the stigmator **14a,** the basic hardware configuration remains unchanged from that shown in FIGS. 3A-3B, deactivation of the single electrostatic quadrupole **13b** once again causes the detector plane **8** to be conjugate to the back focal plane **6** of objective lens system **2,** as indicated by the graphical projection lines **12a, 12b.** Thus, the activation and deactivation of the single electrostatic quadrupole **13b** can be used to switch between recording of a diffraction pattern and recording of a sample image, and vice versa.

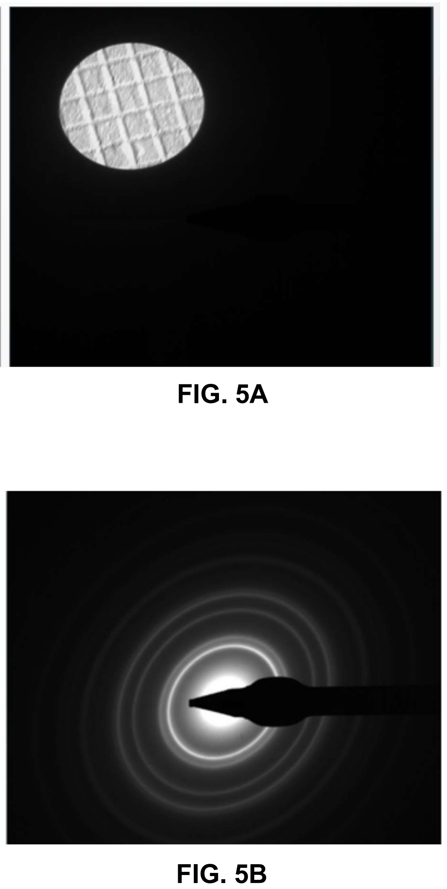

FIG. 5A is an image of a sample as may be generated by an electron microscope substage assembly in which optical components are arranged as in FIG. 4 with stigmator **14a** and quadrupole component **13b** both activated. FIG. 5B is a diffraction pattern of the sample as may be obtained using the same system and same sample as imaged in FIG. 5A but with the quadrupole **13b** de-activated and the stigmator remaining activated. Thus, using the configuration shown in FIG. 4, it is possible to rapidly switch between diffraction and sample imaging by activating and deactivating only one optical component, viz., the quadrupole **13b** at the selected aperture plane **7.** A multiple exposure in which the diffraction pattern and the sample image are superimposed may be obtained by switching between the two modes during a single camera exposure of a detector. In an alternative but less-preferred embodiment, the single stigmator **14a** may be replaced by two stigmators that are positioned downstream from the back focal plane **6** such that the combined action of the pair of stigmators acts as and has the same effect as the single stigmator **14a** at the back focal plane. However, it is found that this alternative configuration is less preferable, as it has been found to cause some image deformation.

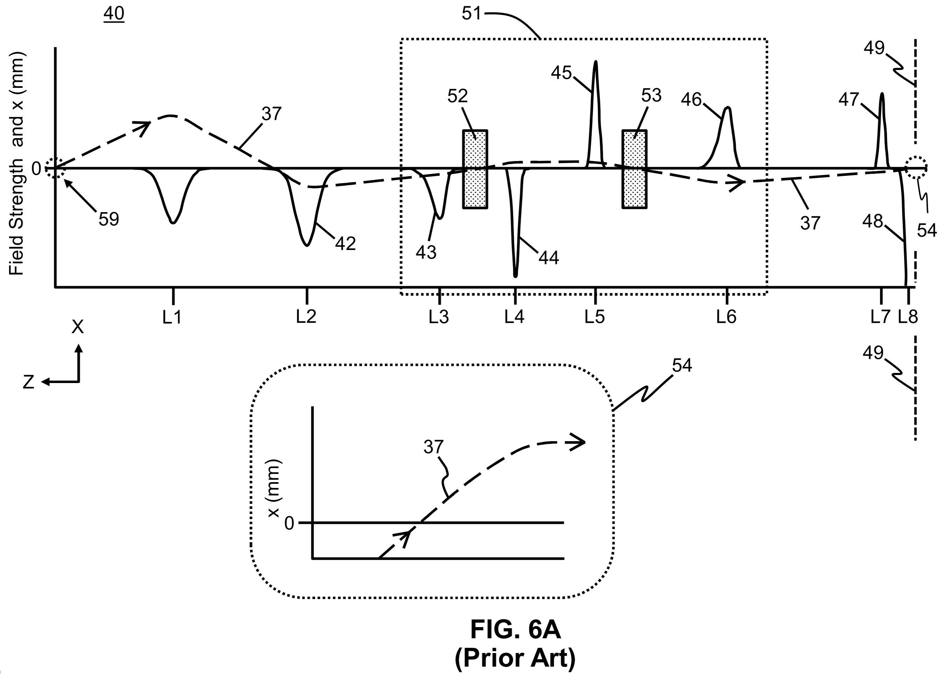

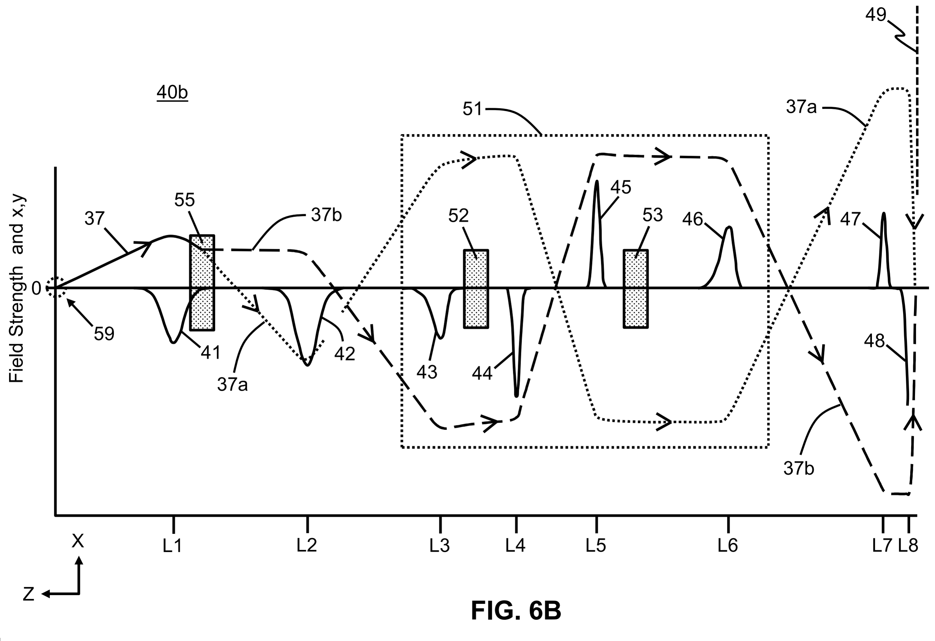

FIG. 6A is a portion of a set of optical components **40** within a beam delivery portion of an electron microscope column (not shown) of a transmission electron microscope (TEM) that is configured and operated, in a known fashion, to deliver a collimated electron beam onto a sample. FIG. 6B is a schematic depiction of a modified version of the optical components set **40** of FIG. 6A, the modification being in accordance with the present teachings. The Z-axis shown in FIGS. 6A and 6B corresponds to the column axis **10** shown in FIGS. 1, 3A, 3B and 4 as well as the axis **110** shown in FIG. 2. A sample plane **49** having a sample thereon is depicted on the righthand side of each of FIGS. 6A and 6B.

An electron source (not shown) and at least a condenser lens (not shown) and an intermediate lens (not shown) are located to the left of the left-hand side of each of FIGS. 6A and 6B. The electron source provides a stream of electrons, which comprises a plurality of rays, to the optical components of the illumination column. The rays are collimated and subsequently focused by one or more not-illustrated lenses located to the left of the leftmost portion of each of FIG. 6A and FIG. 6B. The leftmost portion of each of these figures is a focal point **59** of the not-illustrated lenses. The path of a single ray **37** is illustrated in FIG. 6A. FIG. 6B shows the path of the same ray **37** as well as the paths of separate sub-rays **37a, 37b** into which the ray **37** may be divided in accordance with the present teachings.

The known optical components set **40** comprises a plurality of lenses, the positions of which are denoted as **L1, L2, L3, ..., L8** in both FIG. 6A and FIG. 6B. The lenses themselves are not specifically depicted in either FIG. 6A or FIG. 6B. However, the field-strength plots **41, 42, 43, 44, 45, 46, 47** and **48** indicate, in graphical format, the field strength of each such lens at its respective position. Four of the lenses - specifically lenses **L3, L4, L5** and **L6,** are included within a known probe aberration corrector **51.** The inset of FIG. 6A is an enlarged version of circled region **54** in the vicinity of sample plane **49** showing that, via the beam manipulations of the various optical components **40,** the ray **37,** as well as any other rays that pass through focal point **52,** the electrons are introduced onto the sample as a circular collimated beam that is parallel to the Z-axis. As depicted in FIG. 6A, the optical components, so configured, fulfill their purpose of delivering a collimated beam to the sample for TEM studies.

The known lens system **51** is a probe Cs-corrector of the hexapole type, where Cs is the spherical aberration coefficient. Key components of the probe aberration corrector **51** are the magnetic hexapole elements **52** and **53.** The hexapole elements generate strong hexapole fields which are used to generate a negative Cs. For parasitic aberration correction (i.e., caused by mechanical errors), these hexapole elements **52** and **53** also generate relatively weak dipole and quadrupole fields, and these weak fields are deployed in FIGS. 6A-6B. With regard to the following discussion, these quadrupole fields do not need to be switched, i.e., they have the same excitations in both of FIG. 6A and FIG. 6B.

FIG. 6B is a schematic depiction of a modified version of the set of optical components that are shown FIG. 6A. In accordance with the present teachings, the optical components set **40b,** are modified relative to the components set **40** by incorporation therein of an additional quadrupole element **55** in the beam path at a position adjacent to and just downstream from the **L1** lens position. The quadrupole element **55** is configured to, in operation, separate the ray **30** into sub-rays **30a** and **30b** which, when acted upon by the existing downstream lenses **L2, L3, L4,** ..., **L8** and quadrupoles **52, 53** reconverge to a finely-focused, sub-Ångstrom-size probe beam on the sample plane. Furthermore, the inventors have discovered that the ray-path modifications shown in FIG. 6B do not interfere with the proper functioning of the aberration corrector **51.** Accordingly, by activation of the single quadrupole optical component **55,** the operational mode of the electron microscope system may be rapidly transformed into an atomic-resolution STEM, STEM-EDS or STEM-EELS mode. De-activation of the quadrupole **55** transforms the operational mode back to TEM mode. Moreover, the operation of the microscope may be rapidly switched between the different operational modes as desired.

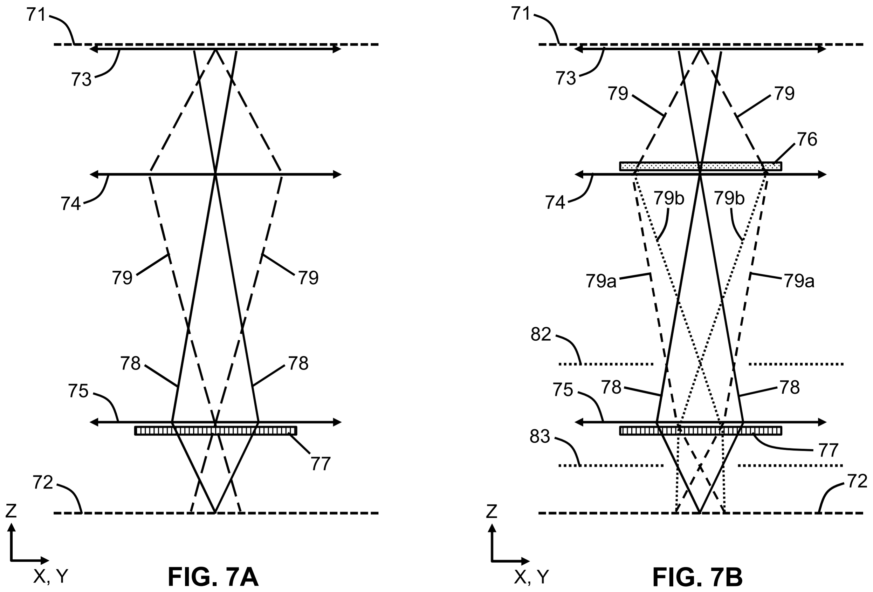

FIG. 7A is a schematic depiction of a portion of a set of substage components of a transmission electron beam microscope that are provided in a configuration that includes a laser phase plate for image contrast enhancement. FIG. 7A also shows ray paths of representative field rays **79** and representative axial rays **78.** The substage components that are illustrated in FIG. 7A are disposed in the region between a sample plane **71** and a diffraction plane **72.** The components of the substage assembly of FIG. 7A include an objective lens system **73,** a first transfer lens system **74** that is disposed at or near a first intermediate image plane of the objective lens system, and a second transfer lens system **75** that is disposed at or near an intermediate diffraction plane at which field rays **79** converge. It should be kept in mind that the diagram is highly schematic and that each component that is described as a "lens" may, in fact, comprise a multicomponent lens system or lens assembly.

In addition to the above-noted components, the substage also includes a laser phase plate **77** that is also disposed at or near the intermediate diffraction plane at which the second transfer lens **75** is positioned. Generally, a laser phase plate is a photonic optical cavity that is placed in the path of an electron beam. A laser beam that is emitted from a laser (not shown) is further amplified in a laser cavity and forms a tight focus that coincides with certain selected electron ray paths. The ponderomotive force that is exerted on electrons by the energy of photonic standing waves that are created from the laser beam within the cavity induces a phase shift for some electrons. The interference between phase-shifted electrons and non-phase-shifted electrons is utilized to enhance contrast in TEM images of the sample.

One of the main difficulties in the use of a phase plate is in aligning the phase plate with the electron beam, which requires precise control over the position and orientation of the phase plate. The present inventors have discovered that, as depicted in FIG. 7B, by incorporating a switchable electrostatic quadrupole element **76** adjacent to the first transfer lens system **74** at the first intermediate image plane of the objective lens system, the laser interference fringes may be made visible at an image plane. Thus, the pattern of interference fringes may be detected and displayed simultaneously with the making of alignment adjustments to the laser beam.

Referring, now, to both FIGS. 7A and 7B, it may be observed that axial rays **78** remain focused at the diffraction plane **72** regardless of whether the quadrupole **76** is present and, if the quadrupole is present, regardless of whether the quadrupole is in an activated state. The reason that the axial ray paths are unaffected by the presence or activation state of the quadrupole **76** is because the quadrupole is positioned at a plane at which the axial rays **78** are focused by objective lens system **73.** In contrast, if the quadrupole **76** is absent (FIG. 7A) or is otherwise inactivated, then the field rays **79** are focused onto the plane of the laser phase plate **77** at the diffraction plane **75,** a configuration which is referred to herein as an "on-plane" configuration. In the on-plane configuration, image contrast is optimized if one of the antinodes in the laser focal point coincides with the focus of the field rays **79.**

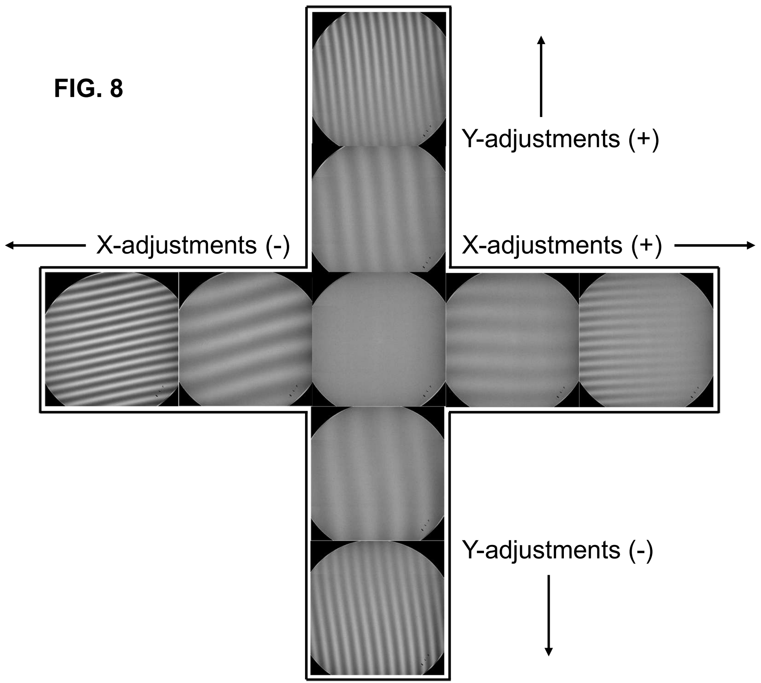

If the quadrupole **76** is present and activated, then each field ray **79** is split into a first ray **79a** and a second ray **79b.** Because of this splitting, the field rays **79b** (dotted lines in FIG. 7B) are caused to focus, by first transfer lens system **74** at an upper focal plane **82.** At the same time, the field rays **79a** (dashed lines) are caused to focus, by both the first transfer lens system **74** and the second transfer lens system **75,** at a lower focal plane **83.** This condition is referred to herein as an "off-plane" configuration. If, in the off-plane configuration, the switchable electrostatic quadrupole is configured such that the upper focal plane **82** and lower focal plane **83** are essentially equidistant from the nominal focal plane **75** as depicted in FIG. 7B, then the image of the sample will be superimposed with fringes from the laser, as sets of light and dark bands in the electron microscope image (e.g., see FIG. 8). Under such conditions, it is possible to observe, at a detector plane that is conjugate to the image plane, the spatial effects of the destructive and constructive laser standing wave interference within the optical cavity. Note that, since the electrostatic quadrupole **76** is located at or near an image plane **74,** the activation and deactivation of the electrostatic quadrupole does not affect the image of an object but only affects the visibility of the laser fringes, as superimposed upon the image.

The pattern of interference fringes that are observed in off-plane configurations provide information relating to the relative alignment between the laser beam and the electron beam. The off-plane fringe pattern that appears when going from a well-aligned on-plane situation to an off-plane situation can be used as a reference image to keep the electron beam well aligned to the laser beam. Switching between the on-plane imaging mode and the off-plane mode showing interference fringes can be performed using a rapid-response switching apparatus such as the electrostatic quadrupole **76.** This procedure can allow an analyst to quickly alternate between the viewing of fringes and the viewing of a sample image to obtain optimum image contrast and correlate image contrast with fringe patterns in near real time.

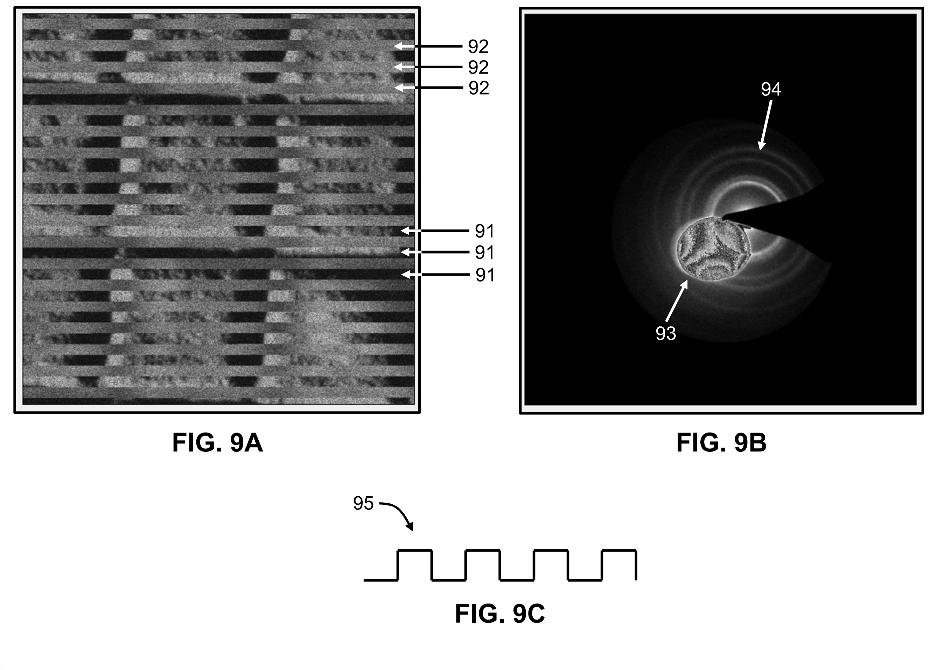

Similarly, the ability to rapidly switch between and imaging mode and a diffraction mode using a rapid response switching apparatus as described herein may be necessary in cases of microscopic investigation of samples that either move (either intentionally or unintentionally), degrade, decompose, react, sublimate, or otherwise change during the course of the investigation. In such instances, it may be advantageous or even necessary to alternate modes at a repetition rate that is equal to or faster than a frame acquisition rate of a camera detector or a scan repetition rate of a scanning system. A double-exposure or multiple exposure may be made by making the switching time short compared to the camera frame time. For example, FIG. 9A is a composite image, acquired by scanning of a sample using an STEM apparatus, of a sample that comprises a plurality of diffraction image swaths **92** that are interleaved with sample image swaths **91** wherein the switching between sample imaging and diffraction imaging is controlled by application of a 50 Hertz voltage waveform, as shown in FIG 9C to an electrostatic quadrupole switching apparatus. Each set of swaths **91, 92** may be separately compared and/or correlated to monitor changes in the sample, if any, or in microscope performance, if any, over the course of data acquisition. FIG. 9B is a composite image obtained by assembling the STEM image swaths **91** into a single image **93** of the sample and assembling the diffraction image swaths **92** into a Ronchigram **94.** The shapes, patterns, and symmetries observed in the Ronchigram indicate the presence and nature of lens aberrations, if any. By analyzing these patterns, it is possible to detect possible image distortions in the sample image **93** and to adjust the microscope, as necessary, to correct any aberration that create the distortions.

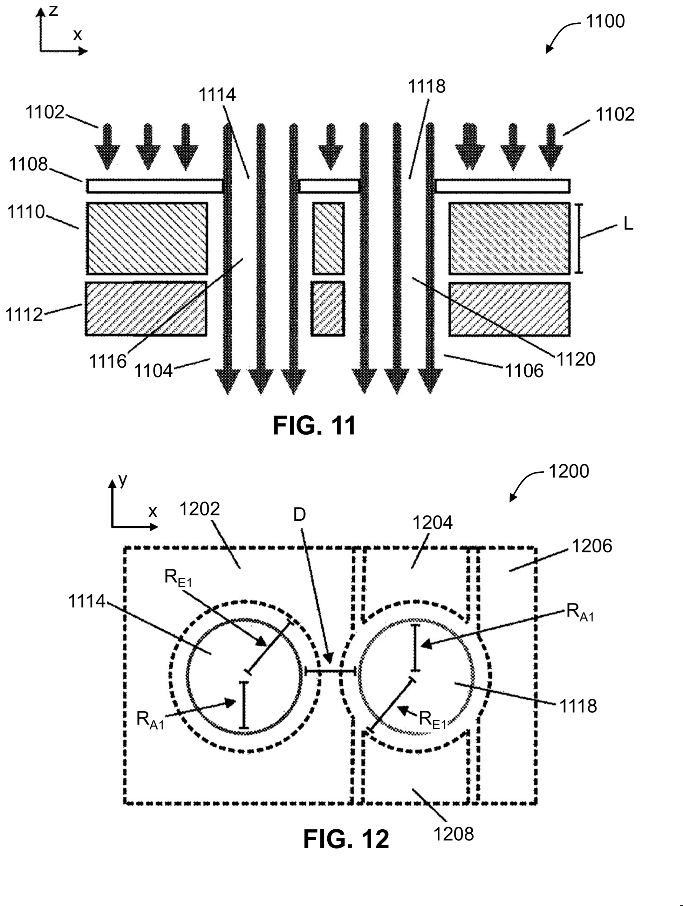

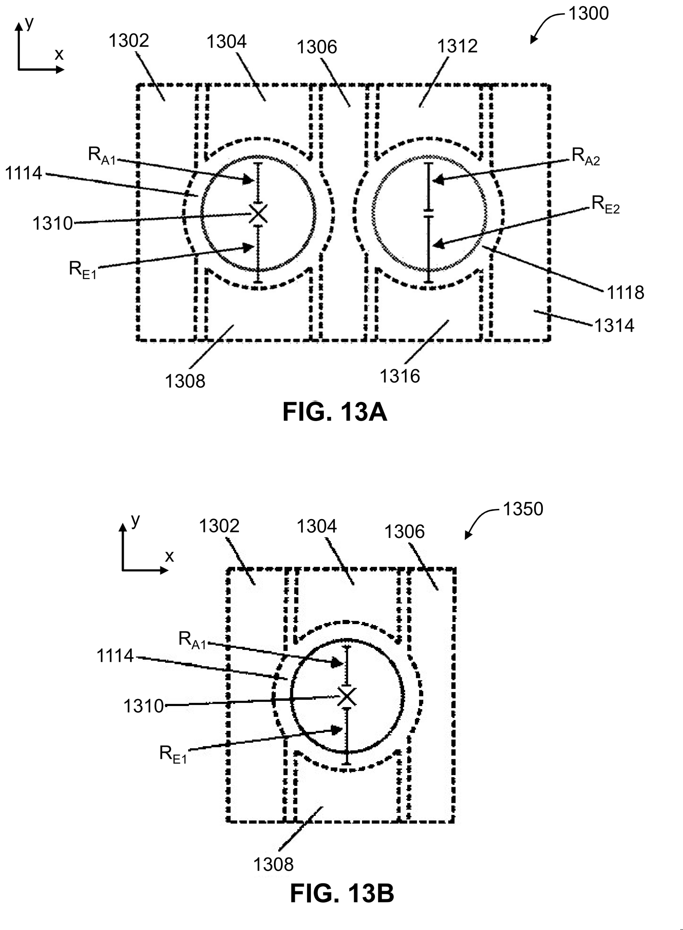

FIGS. 11, 12, and 13A depict exemplary bifocal beam-forming devices, as described in Pre-Grant Publication 2021/0302333-A1, that may be modified for use (e.g., FIG. 13B) as electrostatic multipoles in apparatuses in accordance with the present teachings. FIG. 11 shows a cross section of an example embodiment of an example bifocal beam-forming device **1100** that may be fabricated by the same methods that are used to fabricate general micro-electromechanical systems (MEMS). Specifically, FIG. 11 illustrates a cross section of a MEMS-like device **1100** configured to split a flow of a plurality of electrons **1102** into a first electron beam **1104** and a second electron beam **1106,** and to generate an electromagnetic field pattern that applies at least a quadrupole lensing effect to at least the second electron beam **1106.** The at least quadrupole lensing effect causes the first electron beam **1104** and the second electron beam **1106** to have different focal properties. For example, the quadrupole lensing effect may apply a positive lensing effect in one meridional plane (e.g. a y-z plane) and a negative lensing effect in a perpendicular meridional plane (e.g., an x-z plane), causing a different change to the focal properties in each of the two meridional planes. FIG. 11 illustrates a cross section through the MEMS device **1100** as including a surface layer **1108,** an electrode layer **1110,** and an optional shielding layer **1112.** In FIG. 11, the surface layer **1108** is shown as comprising a thin material (e.g., a foil) upon which the electrons **1102** are incident. In other embodiments, the surface layer **1108** may not correspond to a separate component layer, but instead, may correspond to an upper surface of one or more components of the MEMS device **1100** upon which the electrons **1102** are incident.

Still with reference to FIG. 11, the surface layer **1108** defines a first entrance **1114** to a first aperture **1116** and a second entrance **1118** to a second aperture **1120.** The first entrance **1114** allows a first portion of the electrons **1102** (i.e., the first electron beam **1104)** to pass into the first aperture **1116** and through the MEMS device **1100.** Similarly, the second entrance **1118** allows a second portion of the electrons **1102** (i.e., the second electron beam **1106)** to pass into the second aperture **1120** and through the MEMS device **1100.** The surface layer **1108** inhibits the ability of the remaining portions of electrons **1102** to pass into and/or through the MEMS device **1100.**

The electrode layer **1110** comprises a plurality of micro-electrodes that are shaped, positioned, or otherwise configured such that when corresponding voltages are applied to the one or more electrodes, the one or more electrodes generate electromagnetic field patterns that apply a lensing effect to one or both of the first electron beam **1104** and the second electron beam **1106.** The lensing effect is such that the focal properties of the two beams are modified such that they have different corresponding focal properties. One or more of the magnitude of the voltages applied to the electrodes, the shape of the electrodes, and the thickness (L) of the electrodes can be modified to change the strength of the generated electromagnetic field patterns. According to the present disclosure, the electrodes in the electrode layer **1110** are configured such that they generate at least a quadrupole electromagnetic field pattern that applies at least a quadrupole lensing effect (i.e., dipole field, quadrupole field, hexapole field, octupole field, etc.) to the second electron beam **1106.** In some embodiments, the electromagnetic field pattern may also apply dipole fields to one or both of the first electron beam **1104** and the second electron beam **1106.** Such dipole fields may cause at least one of the electron beams to be deflected in a direction non-parallel to the emission axis, z. FIG. 11 also illustrates the MEMS device **1100** as including an optional shielding layer **1112** that is opposite the surface layer **1108,** and which is configured to at least partially insulate the first electron beam **1104** from the at least quadrupole lensing effects applied to the second electron beam **1106.**

FIG. 12 shows a top-down schematic view of an example of a MEMS electrostatic multipole embodiment **1200** that comprises four electrodes. FIGS. 12 and 13 illustrate in solid lines the first entrance **1114** and second entrance **1118** as defined by surface layer **1108** in solid lines. Additionally, FIGS. 12 and 13 illustrate the components of the electrode layer **1110** in dashed lines. A person having skill in the art would recognize that the dashed lines do not necessarily represent the exact shape, but rather indicate general outlines electrodes in the electrode layer **1110.** FIG. 12 shows the radius R_{A1} of the first entrance **1114** as being lesser than the radius R_{E1} of the first aperture **1116** as at least partially defined by electrode **1202.** In an embodiment of example MEMS device **1200,** the radius R_{A1} may be at or around 10 µm and the radius R_{E1} may be at or around 14 µm or greater. The radius R_{A2} of the second entrance **1118** is shown in FIG. 12 as being lesser than the radius R_{E2} of the second aperture **1120** as at least partially defined by electrodes **1202, 1204, 1206,** and **1208.** However, in other embodiments one or both of radius R_{E1} and radius R_{A1} and/or radius R_{E2} and radius R_{A2} may be the same. The example embodiment **1200** is further shown as having the radius R_{A1} and the radius R_{A2} as being equal and/or approximately equal, however this is not required for all embodiments. The first entrance **1114** and the second entrance **1118** are separated by the distance D.

During use of the example MEMS device **1200,** voltages may be applied to one or more of the electrodes **1202-1208** such that the electrodes generate an electromagnetic field that applies at least a quadrupole lensing effect to the second electron beam. In some embodiments, one or more of the electrodes may be grounded. For example, the example MEMS device **1200** may generate an electromagnetic field that applies at least a quadrupole lensing effect to the second electron beam when a first voltage *V*₁ is applied the electrode **1204,** a second voltage *V*₂ is applied to electrode **1208,** and electrodes **1202** and **1206** are grounded. In various embodiments, *V*₁ and *V*₂ may each be greater than -20V and less than +20V, however larger voltages can also be used.

FIG. 13A shows a top down schematic view of an example embodiment **1300** of a MEMS electrostatic multipole device that comprises seven electrodes. FIG. 13A shows the radius R_{A1} of the first entrance **1114** as being lesser than the radius R_{E1} of the first aperture as at least partially defined by electrodes **1302, 1304, 1306,** and **1308.** FIG. 13A illustrates the first entrance **1114** as being an axial aperture through which the emission axis **1310** of the plurality of electrons passes. The radius R_{A2} of the second entrance **1118** is also shown in FIG. 13A as being lesser than the radius R_{E2} of the second aperture as at least partially defined by electrodes **1306, 1312, 1314,** and **1316.** However, in other embodiments one or both of radius R_{E1} and radius R_{A1} and/or radius R_{E2} and radius R_{A2} may be the same.

During use of the example MEMS device **1300,** voltages may be applied to one or more of the electrodes **1302-1308** and **1312-1316** such that the electrodes generate an electromagnetic field that applies at least a quadrupole lensing effect to the second electron beam. In some embodiments, one or more of the electrodes may be grounded. For example, the example MEMS device **1300** may generate an electromagnetic field that applies at least a quadrupole lensing effect to the second electron beam when a first set of voltages between the values of -20V and +20V are applied to electrodes **1304, 1308, 1312,** and **1316,** a second set of voltages between the values of -5V and +5V is applied to electrodes **1302** and **1314,** and electrode **1306** is grounded.

The above-mentioned known bifocal beam forming systems **1100, 1200, 1300** are designed to separate a single charged-particle beam into separate charged-particle beams and to independently focus and/or shape two separated beams. However, many charged-particle-beam systems described herein do not require such complex beam separation and beam shaping operations. Nonetheless, the structures of the known bifocal beam forming systems may be simplified for use as electrostatic quadrupole apparatuses as have been described herein above. For example, FIG. 13B illustrates an exemplary electrostatic quadrupole **1350** that comprises a subset of the components of the bifocal beam system **1300.** Specifically, since there may be no need for splitting of a charged-particle beam into two separate beams, the second entrance **1118** and its corresponding second aperture may be eliminated from the structure. The elimination of the second aperture and second entrance also eliminates the need for electrodes **1312, 1314** and **1316** that are illustrated in FIG. 13A as components of the bifocal beam forming apparatus **1300.** The resulting simplified apparatus **1350** (FIG. 13B) includes only entrance **1114,** the circular shape of which is defined by the shapes of the surrounding four electrodes **1302, 1304, 1306,** and **1308.**

A person having skill in the art would understand that the dashed lines in FIGS. 12, 13A and 13B represent example configurations of electrodes, and that experimentation would provide multiple electrode configurations (e.g., electrode size, electrode shape, quantity of electrodes, layout of electrodes, combination of voltages applied to electrodes, etc.) that cause the electrodes to generate an electromagnetic field that applies at least a quadrupole lensing effect to a charged-particle beam. As but one example, it may be recognized, by a person of ordinary skill in the art, that application of a first electrical potential, *V*₁, to opposing electrodes **1302** and **1306** of the electrostatic quadrupole apparatus **1350** in conjunction with the simultaneous application of a second, different electrical potential, *V*₂, to the electrodes **1304** and **1308** may correspond to an "activation" of the apparatus **1350** that can generate a quadrupole lensing effect to a charged particle beam that passes through the aperture. Further, according to this example, application of essentially a same electrical potential to all four electrodes **1302, 1304, 1306,** and **1308** may comprise a "deactivation" of the apparatus **1350.** It should be noted that, as used here, the "application" of an electrical potential to an electrode may include grounding of the electrode and/or allowing the electrical potential of the electrode to "float".

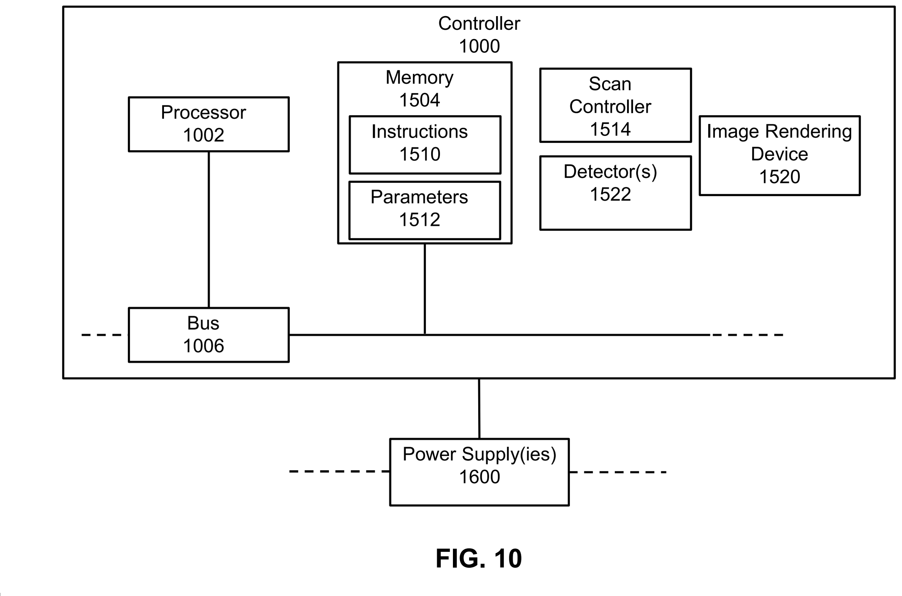

FIG. 10 depicts block diagrams of a controller **1000** and power supplies **1600** for a microscope system according to certain aspects of the present disclosure. As shown, the controller **1000** includes a processor **1002** communicatively coupled to memory **1504.** The processor **1002** can include one processing device or multiple processing devices. Non-limiting examples of the processor **1002** include a Field-Programmable Gate Array (FPGA), an application specific integrated circuit (ASIC), a microprocessor, or any combination of these. The processor **1002** can execute instructions **1510** stored in the memory **1504** to perform operations, such as the operations of microscopes, processes, scans, and operations associated with the various methods described herein. In some examples, the instructions **1510** can include processor-specific instructions generated by a compiler or an interpreter from code written in any suitable computer-programming language, such as C, C++, C#, Python, or Java.

The memory **1504** can include one memory device or multiple memory devices. The memory **1504** can be non-volatile and may include any type of memory device that retains stored information when powered off. Non-limiting examples of the memory **1504** include electrically erasable and programmable read-only memory (EEPROM), flash memory, or any other type of non-volatile memory. At least some of the memory **1504** can include a tangibly embodied non-transitory computer-readable medium from which the processor **1002** can read instructions **1510** via bus **1006.** The bus **1006** may be a communication and/or power bus that enables processor **1002** to communicate with memory **1504.** The non-transitory computer-readable medium can include electronic, optical, magnetic, or other storage devices capable of providing the processor **1502** with the instructions **1510** or other program code. Non-limiting examples of the non-transitory computer-readable medium include magnetic disk(s), memory chip(s), RAM, an ASIC, or any other medium from which a computer processor can read instructions **1510.**

The memory **1504** can further include information about parameters **1512** (e.g., calibrations, tuning, stage positions, beam intensity, etc.), beam scanning controller **1514** (e.g., scan coordinates, stored images, etc.), detector operation (e.g., detector control, sensitivity, etc.), and image rendering devices **1520.** The controller **1000** can receive the information about operating parameters from a charged particle microscope, such as an STEM or a TEM. At least some of the information about any of the controller components can be pre-stored. The parameters **1512** can include operating parameters associated with an electron microscope system, such as a desired energy/primary energy of an electron beam, an energy spread of an energy loss spectrum, lockup mechanisms, feedback loops, etc.

Any of the systems described herein may include a controller system **1000** that may automatically cause one or more power supplies **1600** to adjust voltages that are applied to one or more ray-path switching devices as discussed herein, such as a such as one or more electrostatic quadrupole elements and/or one or more stigmators for the purpose of switching an operating mode of a charged-particle-beam microscope apparatus from a first operating mode to a second operating mode and/or from the second operating mode to the first operating mode. The controller system may be electronically connected to computer readable memory **1504** that provides program instructions **1510** to the controller system that, when executed by the controller system, cause the controller system to cause the one or more power supplies to provide a sequence of voltage configurations to the one or more beam-path switching devices that cause repetitive switching of the operating mode of the charged-particle-beam microscope apparatus between a first and a second operating mode.

The controller system may also be in electronic communication with one or more other components of the charged-particle-beam microscope apparatus such as, for example, a sample stage on which a sample of interest is mounted and which may be moved by one or more actuators. In such instances, the controller system may be configured to cause the one or more power supplies to transmit electronic and/or electrical signals to the one or more actuators to move the sample stage in coordination with the repetitive switching of operating modes described above. The controller system may be instructed to cause these sample stage movements by execution of program instructions received from the computer readable memory.

The controller system may also be in electronic communication with one or more detector systems of the charged-particle-beam microscope apparatus and may be operable to control the timing of data acquisitions by the one or more detector systems under the control of program instructions received from the computer readable memory. For example, the program instructions **1510,** when executed by the processor(s) **1002** of the controller system **1000,** may be operable to cause the controller system to cause the one or more detector systems to acquire data at certain times that are coordinated with the switching of an operating mode of a charged-particle-beam microscope apparatus from a first operating mode to a second operating mode and/or from the second operating mode to the first operating mode as described herein.

Although the present invention has been described in accordance with the embodiments shown, one of ordinary skill in the art will readily recognize that there could be variations to the embodiments and those variations would be within the scope of the present invention. Accordingly, many modifications may be made by one of ordinary skill in the art without departing from the scope of the appended claims. For example, various embodiments of the invention may be described by one or more of the following clauses:
Clause 1. A method, within a charged particle beam (CPB) microscope, of rapidly switching between a first imaging or data acquisition mode and a second imaging or data acquisition mode, comprising:
   activating a switchable multipole element of the CPB microscope, wherein the switchable multipole element is configured to create, when activated, a quadrupole field, so as to either cause or enable the CPB microscope to generate a first set of one or more images or data sets, the first set of one or more images or data sets comprising information relating to a sample in accordance with the first imaging or data acquisition mode; and
   de-activating the switchable multipole element so as to either cause or enable the CPB microscope to generate a second set of one or more images or data sets, the second set of one or more images or data sets comprising information relating to the sample in accordance with the second imaging or data acquisition mode.
Clause 2. A method as recited in clause 1, wherein the switchable multipole element is a switchable electrostatic multipole element.
Clause 3 A method as recited in clause 2, wherein a switching time of the switchable electrostatic multipole element is not greater than 100 milliseconds or, alternatively, is not greater than 10 milliseconds or, alternatively, is not greater than 1 millisecond or, alternatively, is not greater than 500 microseconds or, alternatively, is not greater than 10 microseconds or, alternatively, is not greater than 1 microsecond or, alternatively, is not greater than 500 nanoseconds or, alternatively, is not greater than 50 nanoseconds.
Clause 4. A method as recited in clause 1, wherein the switchable multipole element is repeatedly activated and de-activated, within a single detector frame time, in accordance with a duty cycle,
   wherein each activating causes the CPB microscope to generate a component image in accordance with a first imaging mode and each deactivating causes the CPB microscope to generate a component image in accordance with a second imaging mode, and
   wherein a superposition of the component images generates a multiple-exposure composite image.
Clause 5. A method as recited in clause 4, wherein the switchable multipole element is disposed within an image projection system of the CPB microscope that projects, onto a detector, a diffraction pattern when the switchable multipole element is deactivated.
Clause 6. A method as recited in any one of clauses 1-5, wherein the image projection system further comprises an active stigmator disposed at a back focal plane of an objective lens,
   wherein each activating and deactivating of the switchable multipole element comprises activating and deactivating, respectively, a switchable multipole element that is positioned at a selected aperture plane of an objective lens system of the image projection system, and
   wherein each activating corresponds to generation of an image of the sample and each deactivating corresponds to generation of a diffraction pattern from the sample.
Clause 7. A method as recited in clause 6, wherein the switchable multipole element is a switchable electrostatic multipole element and a switching time of the switchable electrostatic multipole element is not greater than 100 milliseconds or, alternatively, is not greater than 10 milliseconds or, alternatively, is not greater than 1 millisecond or, alternatively, is not greater than 500 microseconds or, alternatively, is not greater than 10 microseconds or, alternatively, is not greater than 1 microsecond or, alternatively, is not greater than 500 nanoseconds or, alternatively, is not greater than 50 nanoseconds.
Clause 8. A method as recited in clause 5, wherein the image projection system further comprises a pair of active stigmators disposed between the back focal plane and a projection lens, the pair of active stigmators having the same effect on charged-particle-beam pathways within the image projection as that of a single stigmator disposed at a back focal plane of an objective lens,
   wherein each activating and deactivating of the switchable multipole element comprises activating and deactivating, respectively, a switchable multipole element that is positioned at or proximal to an intermediate image plane of the image projection system; and
   wherein each activating corresponds to generation of an image of the sample and each deactivating corresponds to generation of an electron diffraction pattern from the sample.
Clause 9. A method as recited in clause 5,wherein the image projection system comprises a laser phase plate that is disposed at a diffraction plane conjugate to the objective lens back focal plane onto which a laser beam is directed,
   wherein each activating and deactivating comprises, respectively, activating and deactivating a switchable multipole element that is disposed at or proximal to an image plane of an objective lens of the image projection system, and
   wherein each activating causes superposed images of the sample and of laser interferences fringes to be acquired by a detector.
Clause 10. A method as recited in clause 9, wherein the switchable multipole element is a switchable electrostatic multipole element and a switching time of the electrostatic multipole element is not greater than 100 milliseconds or, alternatively, is not greater than 10 milliseconds or, alternatively, is not greater than 1 millisecond or, alternatively, is not greater than 500 microseconds or, alternatively, is not greater than 10 microseconds or, alternatively, is not greater than 1 microsecond or, alternatively, is not greater than 500 nanoseconds or, alternatively, is not greater than 50 nanoseconds.
Clause 11. A method as recited in any one of clauses 1-5, wherein the switchable multipole element is disposed within a CPB microscope column that directs a beam of charged particles onto a sample.
Clause 12. A method as recited in clause 11, wherein the switchable multipole element is disposed between a focal point of a beam condenser lens system of the CPB microscope column and an aberration correction system of the CPB microscope column,
   wherein activating of the switchable multipole element causes the CPB microscope column to deliver a focused probe beam onto the sample that enables a scanning transmission microscope (STEM) operational mode, and
   wherein de-activating of the switchable multipole element causes the CPB microscope column to deliver a collimated beam onto the sample that enables a transmission electron microscope (TEM) operational mode.
Clause 13. A method as recited in clause 12,
   wherein the aberration correction system comprises a spherical aberration corrector of the hexapole type that comprises two active magnetic hexapole elements that generate a negative spherical aberration correction, and
   wherein, upon the activating of the switchable multipole element, a focused circular probe beam is delivered to a selected point on the sample.
Clause 14. A method as recited in clause 13, wherein the probe beam is focused to a sub-Ångstrom-diameter spot.
Clause 15. A method as recited in clause 1,
   wherein the CPB microscope is a Scanning Transmission Electron microscope,
   wherein the first imaging mode is a sample imaging mode,
   wherein the second imaging mode is an electron diffraction mode, and
   wherein the switchable multipole element is repeatedly activated and de-activated during scanning of an electron beam across the surface of the sample.
Clause 16. A charged particle beam (CPB) microscope system comprising:
   a CPB column for configured to transmit a charged particle beam from the charged particle beam source onto a sample;
   an optics assembly comprising transfer optics that are configured to transfer charged particles that are either transmitted through the sample or scattered by the sample to a detector; and
   a switchable multipole element member of either the CPB column or the optics assembly, wherein the switchable multipole element is configured to create, when activated, a quadrupole field and is configured such that:
      activating the switchable multipole element either causes or enables the CPB microscope to generate a first set of one or more images or data sets, the first set of one or more images or data sets comprising information relating to the sample in accordance with a first imaging or data acquisition mode; and
      de-activating the switchable multipole element either causes or enables the CPB microscope to generate a second set of one or more images or data sets, the second set of one or more images or data sets comprising information relating to the sample in accordance with a second imaging or data acquisition mode.
Clause 17. A charged particle beam (CPB) microscope system as recited in clause 16, further comprising an image rendering device that is configured to render a multiple-exposure composite image that is a superimposition of one or more images of the first set of one or more images or data sets onto one or more images of the second set of one or more images or data sets.
Clause 18. A CPB microscope as recited in clause 16, wherein the switchable multipole element is a switchable electrostatic multipole element and wherein a switching time of the switchable electrostatic multipole element is not greater than 100 milliseconds or, alternatively, is not greater than 10 milliseconds or, alternatively, is not greater than 1 millisecond or, alternatively, is not greater than 500 microseconds or, alternatively, is not greater than 10 microseconds or, alternatively, is not greater than 1 microsecond or, alternatively, is not greater than 500 nanoseconds or, alternatively, is not greater than 50 nanoseconds.
Clause 19. A Transmission Electron Microscope (TEM) system comprising:
   an image projection system comprising:
   an objective lens system configured to receive electron rays from a sample and having a back focal plane;
   a projection lens system disposed between the objective lens system and a detector; and
   a first switchable multipole element that is configured to create, when activated, a quadrupole field and that is positioned at a selected aperture plane of the objective lens system and that is configured to be alternately activated and deactivated,
   wherein activation of the first switchable multipole element causes an image of the sample to be projected onto the detector and deactivation of the switchable multipole element causes a diffraction pattern of the sample to be projected onto the detector.
Clause 20. A TEM system as recited in clause 19, wherein the switchable multipole element is a switchable electrostatic multipole element and wherein a switching time of the first switchable electrostatic multipole element is not greater than 100 milliseconds or, alternatively, is not greater than 10 milliseconds or, alternatively, is not greater than 1 millisecond or, alternatively, is not greater than 500 microseconds or, alternatively, is not greater than 10 microseconds or, alternatively, is not greater than 1 microsecond or, alternatively, is not greater than 500 nanoseconds or, alternatively, is not greater than 50 nanoseconds.
Clause 21. A TEM system as recited in clause 19, wherein the image projection system further comprises:
   a second switchable multipole element that is configured to create, when activated, a quadrupole field and that is positioned at or proximal to an intermediate image plane of the objective lens system, the second switchable multipole element configured to be alternately activated and deactivated,
   wherein simultaneous activation of the first and second switchable multipole elements causes a focused image of the sample to be projected onto the detector and simultaneous deactivation of the first and second switchable multipole elements causes a diffraction pattern of the sample to be projected onto the detector.
Clause 22. A TEM system as recited in clause 21, wherein the second switchable multipole element is a switchable electrostatic multipole element having a switching time that is not greater than 100 milliseconds or, alternatively, is not greater than 10 milliseconds or, alternatively, is not greater than 1 millisecond or, alternatively, is not greater than 500 microseconds or, alternatively, is not greater than 10 microseconds or, alternatively, is not greater than 1 microsecond or, alternatively, is not greater than 500 nanoseconds or, alternatively, is not greater than 50 nanoseconds.

## Claims

1. A method, within a charged particle beam (CPB) microscope, of rapidly switching between a first imaging or data acquisition mode and a second imaging or data acquisition mode, comprising:
activating a switchable multipole element of the CPB microscope, wherein the switchable multipole element is configured to create, when activated, a quadrupole field, so as to either cause or enable the CPB microscope to generate a first set of one or more images or data sets, the first set of one or more images or data sets comprising information relating to a sample in accordance with the first imaging or data acquisition mode; and
de-activating the switchable multipole element so as to either cause or enable the CPB microscope to generate a second set of one or more images or data sets, the second set of one or more images or data sets comprising information relating to the sample in accordance with the second imaging or data acquisition mode.

2. A method as recited in claim 1, wherein the switchable multipole element is a switchable electrostatic multipole element.

3. A method as recited in any one of claims 1-2, wherein the switchable multipole element is repeatedly activated and de-activated, within a single detector frame time, in accordance with a duty cycle,
wherein each activating causes the CPB microscope to generate a component image in accordance with a first imaging mode and each deactivating causes the CPB microscope to generate a component image in accordance with a second imaging mode, and
wherein a superposition of the component images generates a multiple-exposure composite image.

4. A method as recited in claim 3, wherein the switchable multipole element is disposed within an image projection system of the CPB microscope that projects, onto a detector, a diffraction pattern when the switchable multipole element is deactivated.

5. A method as recited in any one of claims 1-4, wherein the image projection system further comprises an active stigmator disposed at a back focal plane of an objective lens,
wherein each activating and deactivating of the switchable multipole element comprises activating and deactivating, respectively, a switchable multipole element that is positioned at a selected aperture plane of an objective lens system of the image projection system, and
wherein each activating corresponds to generation of an image of the sample and each deactivating corresponds to generation of a diffraction pattern from the sample.

6. A method as recited in claim 4, wherein the image projection system further comprises a pair of active stigmators disposed between the back focal plane and a projection lens, the pair of active stigmators having the same effect on charged-particle-beam pathways within the image projection as that of a single stigmator disposed at a back focal plane of an objective lens,
wherein each activating and deactivating of the switchable multipole element comprises activating and deactivating, respectively, a switchable multipole element that is positioned at or proximal to an intermediate image plane of the image projection system; and
wherein each activating corresponds to generation of an image of the sample and each deactivating corresponds to generation of an electron diffraction pattern from the sample.

7. A method as recited in claim 4,wherein the image projection system comprises a laser phase plate that is disposed at a diffraction plane conjugate to the objective lens back focal plane onto which a laser beam is directed,
wherein each activating and deactivating comprises, respectively, activating and deactivating a switchable multipole element that is disposed at or proximal to an image plane of an objective lens of the image projection system, and
wherein each activating causes superposed images of the sample and of laser interferences fringes to be acquired by a detector.

8. A method as recited in claim 7, wherein the switchable multipole element is a switchable electrostatic multipole element and a switching time of the electrostatic multipole element is not greater than 100 milliseconds or, alternatively, is not greater than 10 milliseconds or, alternatively, is not greater than 1 millisecond or, alternatively, is not greater than 500 microseconds or, alternatively, is not greater than 10 microseconds or, alternatively, is not greater than 1 microsecond or, alternatively, is not greater than 500 nanoseconds or, alternatively, is not greater than 50 nanoseconds.

9. A method as recited in any preceding claim, wherein the switchable multipole element is disposed within a CPB microscope column that directs a beam of charged particles onto a sample.

10. A method as recited in claim 9, wherein the switchable multipole element is disposed between a focal point of a beam condenser lens system of the CPB microscope column and an aberration correction system of the CPB microscope column,
wherein activating of the switchable multipole element causes the CPB microscope column to deliver a focused probe beam onto the sample that enables a scanning transmission microscope (STEM) operational mode, and
wherein de-activating of the switchable multipole element causes the CPB microscope column to deliver a collimated beam onto the sample that enables a transmission electron microscope (TEM) operational mode.

11. A method as recited in claim 10,
wherein the aberration correction system comprises a spherical aberration corrector of the hexapole type that comprises two active magnetic hexapole elements that generate a negative spherical aberration correction, and
wherein, upon the activating of the switchable multipole element, a focused circular probe beam is delivered to a selected point on the sample.

12. A method as recited in claim 11, wherein the probe beam is focused to a sub-Ångstrom-diameter spot.

13. A method as recited in claim 1,
wherein the CPB microscope is a Scanning Transmission Electron microscope,
wherein the first imaging mode is a sample imaging mode,
wherein the second imaging mode is an electron diffraction mode, and
wherein the switchable multipole element is repeatedly activated and de-activated during scanning of an electron beam across the surface of the sample.

14. A method as recited in any preceding claim, wherein the switchable multipole element is a switchable electrostatic multipole element and a switching time of the switchable electrostatic multipole element is not greater than 100 milliseconds or, alternatively, is not greater than 10 milliseconds or, alternatively, is not greater than 1 millisecond or, alternatively, is not greater than 500 microseconds or, alternatively, is not greater than 10 microseconds or, alternatively, is not greater than 1 microsecond or, alternatively, is not greater than 500 nanoseconds or, alternatively, is not greater than 50 nanoseconds.
